(19) **Europäisches Patentamt / European Patent Office / Office européen des brevets**

(11) **EP 3 296 691 A1**

(12) # EUROPEAN PATENT APPLICATION
published in accordance with Art. 153(4) EPC

(43) Date of publication:
**21.03.2018 Bulletin 2018/12**

(21) Application number: **16792949.6**

(22) Date of filing: **10.05.2016**

(51) Int Cl.:
**G01C 19/5712** *(2012.01)* **B81B 7/02** *(2006.01)*

(86) International application number:
**PCT/KR2016/004855**

(87) International publication number:
**WO 2016/182303 (17.11.2016 Gazette 2016/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **12.05.2015 KR 20150066095**

(71) Applicant: **Shin Sung C&T Co., Ltd.**
**Geumcheon-gu, Seoul 08501 (KR)**

(72) Inventors:
• **SONG, Ci Moo**
  **Yongin-si**
  **Gyeonggi-do 16809 (KR)**
• **YOUN, Keun Jung**
  **Incheon 22572 (KR)**
• **KANG, Jeong Sik**
  **Seoul 05245 (KR)**
• **KIM, Yong Kook**
  **Seoul 04407 (KR)**
• **HAN, Seung Ho**
  **Asan-si**
  **Chungcheongnam-do 31471 (KR)**
• **SONG, Hyun Ju**
  **Seoul 03747 (KR)**

(74) Representative: **Gulde & Partner**
**Patent- und Rechtsanwaltskanzlei mbB**
**Wallstraße 58/59**
**10179 Berlin (DE)**

(54) **MEMS GYROSCOPE HAVING 2-DEGREE-OF-FREEDOM SENSING MODE**

(57) Provided is an MEMS gyroscope, which is resistant against external environmental changes such as a microfabrication process error, a vacuum package process error and a temperature change. The MEMS gyroscope comprises: a frame arranged parallel to a bottom wafer substrate; a sensor mass body excited at one degree of freedom in an excitation mode, and of which the displacement is sensed at two degrees of freedom by Cori-olis force in a sensing mode when an external angular velocity is inputted into the frame; and at least two sensing electrodes for sensing the dis-placement of the sensor mass body, the displacement being sensed at the two degrees of freedom, wherein the sensor mass body comprises an inner mass body and an outer mass body encompassing the inner mass body, the outer mass body and the frame are connected by a first support spring, and the outer mass body and the inner mass body are connected by a second support spring.

[FIG. 6]

**Description**

[TECHNICAL FIELD]

The present invention relates to a MEMS gyroscope, and more particularly, a MEMS gyroscope, which uses the principle of sensing the motion of a mass body, rotating in a first direction, in accordance with a Coriolis force generated by exciting the mass body in a second direction, and is robust against an external environmental change such as a micro-machining error, a vacuum packaging error, and a temperature variation.

[BACKGROUND ART]

Micro Electro Mechanical System (MEMS) is a technology embodying the fabrication of mechanical and electrical elements using semiconductor processing. A gyroscope for measuring angular velocity is an example of a device that may incorporate MEMS technology. A gyroscope is able to measure an angular velocity by measuring a Coriolis force that occurs when a rotational angular velocity is applied to an object moving at a certain velocity. The Coriolis force is proportional to the cross product of the moving velocity and the rotational angular velocity, caused by an external force.

In order for the gyroscope to sense the Coriolis force, the gyroscope has a mass body vibrating therein. Typically, the direction in which the mass body is driven in the gyroscope is referred to as an excitation direction, the direction in which the rotational angular velocity is input to the gyroscope is referred to as an input direction, and the direction in which the Coriolis force generated in the mass body is sensed is referred to as a sensing direction.

The excitation direction, the input direction, and the sensing direction are set to intersect one another in a space. Generally, in the gyroscope using the MEMS technology, three directions, consisting of two directions (referred to as horizontal directions or x- and y-axis directions) parallel to a plane formed by a bottom wafer substrate and intersecting each other and one direction (referred to as a vertical direction or a z-axis direction) perpendicular to the surface of the substrate, are set as coordinate axes.

Accordingly, the gyroscope is classified into an x-axis (or y-axis) gyroscope or a z-axis gyroscope. The x-axis gyroscope is a gyroscope whose input direction is a horizontal direction, and the y-axis gyroscope senses a displacement, on a plane, with respect to an axis perpendicular to the x-axis gyroscope, but is substantially the same as the x-axis gyroscope in principle. In order to measure the angular velocity applied in a horizontal direction using the x-axis gyroscope, one of the excitation direction and the sensing direction needs to be set to be the vertical direction. Therefore, the x-axis gyroscope is required to have an excitation electrode for vertically driving a mass body and a sensing electrode for sensing the horizontal displacement of a sensor mass body.

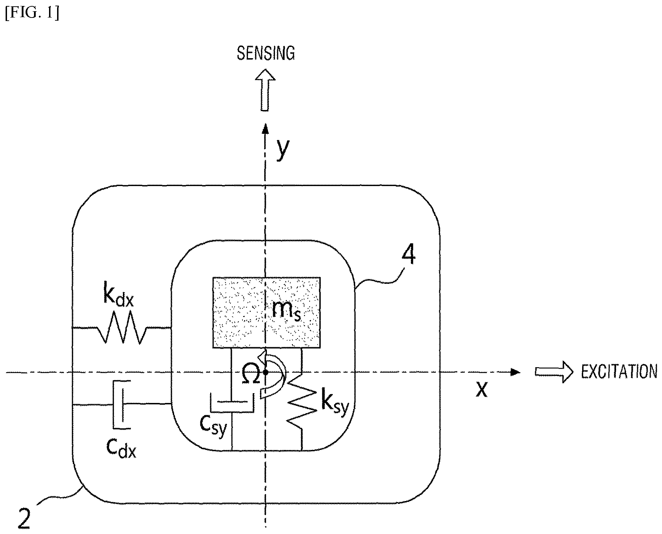

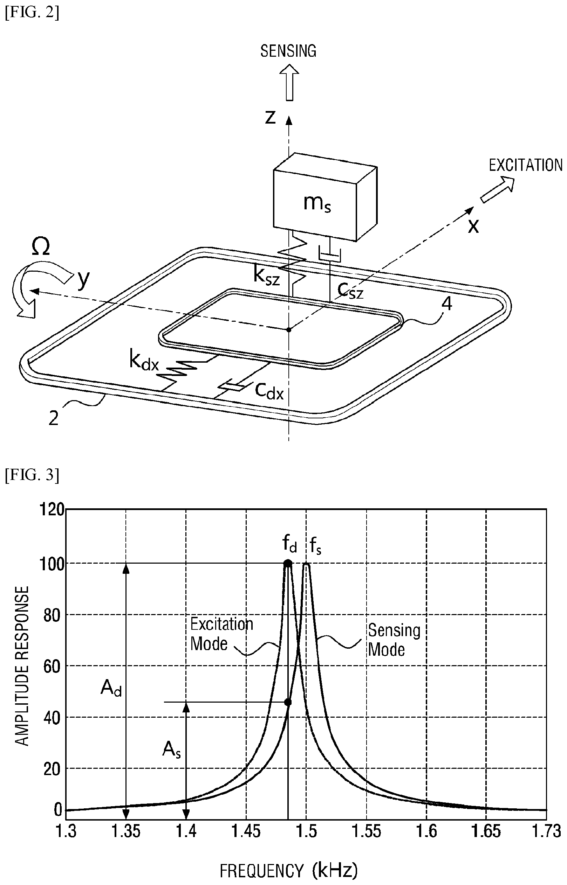

FIG. 1 shows a z-axis MEMS gyroscope having a one Degrees-Of-Freedom (DOF) horizontal excitation/one-DOF horizontal sensing function. FIG. 2 shows an x-axis (or y-axis) MEMS gyroscope having a one-DOF horizontal excitation/one-DOF vertical sensing function. Here, a gyro wafer is provided with a frame 2 and a sensor 4. The sensor 4 is connected to the frame 2 by a spring $k_{dx}$ and an attenuator $c_{dx}$, and a sensor mass body $m_s$ is connected to the sensor 4 by a spring $k_{sy}$ or $k_{sz}$ and an attenuator $c_{sy}$ or $c_{sz}$.

In this MEMS gyroscope, there exists the vibrating sensor mass body $m_s$, and when an angular velocity about an axis (z or y) perpendicular to an excitation direction (x) is applied from the outside, a Coriolis force ($Fc=2m\Omega\times\omega A\sin\omega t$) acts in a third direction (y or z) perpendicular to the plane formed by the excitation direction (x) and a vertical axis (z or y) of the sensor mass body, and the magnitude of the motion of the sensor mass body that varies in accordance with the Coriolis force is detected. Here, $m_s$ denotes the mass of the sensor mass body, $\Omega$ denotes an external angular velocity, $\omega$ ($=2\pi f$) denotes the excitation frequency of the sensor mass body, A denotes the excitation amplitude of the sensor, and t denotes time. Since the performance sensitivity of the MEMS gyroscope is defined as the Coriolis force per unit angular velocity ($Fc/\Omega=2\pi mfA$), it is necessary to increase the mass m of the sensor or the excitation frequency F or the excitation amplitude A of the sensor at a design stage.

Since the maximum amplitude A of the sensor in the conventional z-axis gyroscope of FIG. 1 or the conventional x- or y-axis gyroscope of FIG. 2 is achieved at a resonant frequency having a frequency response curve shown in FIG. 3, it is necessary to match the excitation frequency f of the sensor to the resonant frequency fd of the sensor. Also, a sensing amplitude As of the sensor is determined by how close the resonant frequency fd of the sensor approaches the sensing resonant frequency fs of the sensor, i.e., the degree of frequency matching. However, in order to electrically isolate a parasitic capacitance component caused by an excitation voltage from a sensor output signal, fd should not be completely matched to fs.

Also, as shown in FIG. 3, an excitation amplitude Ad of the sensor increases proportionally with a maximum amplitude-to-static deformation ratio Qd (Quality factor) of a mechanical excitation system, and the sensing amplitude As of the sensor also increases proportionally with a maximum amplitude-to-static deformation ratio Qs (quality factor) of a mechanical sensing system. Accordingly, in order to increase Qd or Qs at the same time, the mechanical excitation/sensing system such as the frame and the sensor is driven after vacuum sealed packaging.

The magnitude of the motion of the sensor mass body generated by the Coriolis force is calculated by measuring a variation in electrical capacitance C between the sensor mass body and a fixed sensing electrode. A sensing signal output from the fixed sensing electrode inevitably includes, as noise, parasitic capacitance generated by a relatively higher excitation voltage than the sensing signal. Thus, as shown in FIG. 3, the overall sensitivity of a gyroscope sensor in which excitation and sensing systems each have one DOF, as shown in FIG. 1 (the z-axis gyroscope) and FIG. 2 (the x- or y-axis gyroscope), is determined by the degree of frequency matching between the sensing resonant frequency fs and the excitation resonant frequency fd of the sensor mass body (i.e., the difference between fs and fd), a maximum amplitude ratio Q of the excitation or sensing system, and the ratio between the output signal of the sensor and the noise caused by the parasitic capacitance, i.e., a signal-to-noise ratio.

Consequently, the closer the resonant frequency fd of the sensor is to the sensing resonant frequency fs, the more the overall sensitivity with respect to an angular velocity can be maximized. Attempts to obtain as high a maximum sensing amplitude As as possible by making fd approach fs, however, cause the difference between the sensing resonant frequency fs and the excitation resonant frequency fd, $\Delta f(=fs-fd)$, to fluctuate sensitively in accordance with an external environment change such as such as a micro-machining error, a vacuum packaging error, and a temperature variation. This increases deviations in the sensing amplitude As between individual chips in a wafer during manufacturing and thus results in a significant decrease in production yield or a decrease in the reliability of the product with regard to an external environment change.

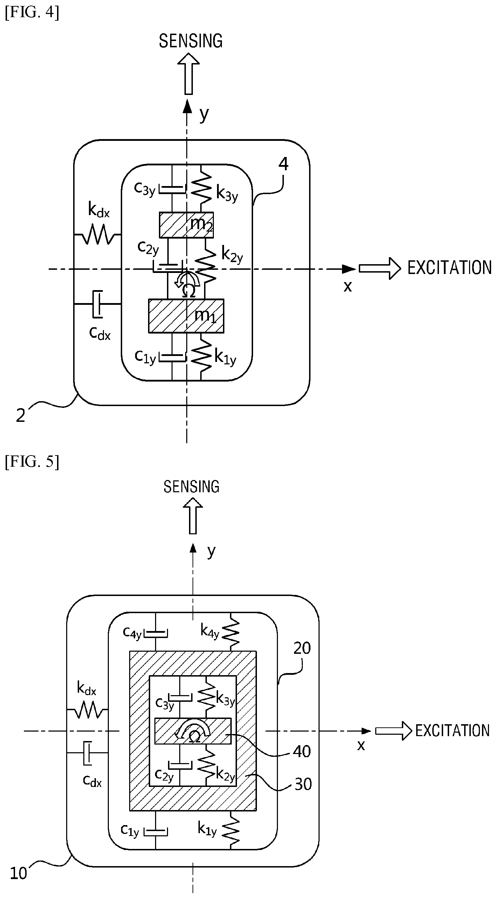

In connection with this issue, Cenk Acar suggests, in U.S. Patent No. 7, 284, 430, dividing a single sensor of a z-axis gyroscope into first and second mass bodies $m_1$ and $m_2$ on an x-y plane, as shown in FIG. 4, assuming that processing errors are inevitable in the process of micro-machining a MEMS structure. Thus, by shifting from an existing one-DOF sense mode having a single resonant frequency to a two-DOF sense mode having two sensing resonant frequencies fs, the excitation or sensing resonant frequency is allowed to slightly change, but without considerably deviating from a flat region.

Cenk Acar's invention can be implemented in the form of a z-axis gyroscope by arranging a plurality of horizontally-sensing non-soft coupling springs on both the inside and the outside of a sensor that is horizontally excited, but in the case of the x- or y-axis gyroscope, it is difficult to realize a plurality of vertically-sensing non-soft coupling springs on both the inside and the outside of the sensor. Also, in the case of the conventional x- or y-axis gyroscope shown in FIG. 2, if the frame is horizontally excited in the x-axis direction and a Coriolis force acts upon the bottom wafer substrate in a vertical direction (z), the surface of the bottom wafer substrate is used as a sensing electrode to vertically sense a variation in the sensor mass body. This type of sensing method is very difficult to uniformly form electrodes to be a predetermined distance apart between the surface of the bottom wafer substrate and the sensor mass body. Also, since there exists parasitic capacitance between the bottom wafer substrate and sensing electrodes on the bottom wafer substrate, the signal-to-noise ratio decreases, and as a result, the performance of sensitivity of the gyroscope deteriorates.

Therefore, a MEMS gyroscope that is easy to fabricate and can maintain the uniformity of sensing amplitude even in the presence of processing errors is needed.

[DISCLOSURE OF INVENTION]

[Technical Problems]

Exemplary embodiments of the present invention provide a MEMS gyroscope that is robust against an external environmental change such as a micro-machining error, a vacuum packaging error, and a temperature variation.

Exemplary embodiments of the present invention also provide a MEMS gyroscope, which provides a two degree-of freedom (DOF) sensing mode using two sensor mass bodies, is easy to fabricate, and can maintain the uniformity of sensing amplitude even in the presence of processing errors.

Exemplary embodiments of the present invention also provide a link structure for ensuring perfect anti-phases between two sensor mass body units in the sensing mode of a MEMS gyroscope.

Additional advantages, subjects, and features of the present invention will be set forth in part in the description which follows and in part will become apparent to those having ordinary skill in the art upon examination of the following or may be learned from practice of the present invention.

[Technical Solutions]

According to an aspect of the present invention, a MEMS gyroscope includes: a frame arranged parallel to a bottom wafer substrate; a sensor mass body excited at one degree of freedom in an excitation mode, and of which the displacement is sensed at two degrees of freedom by a Coriolis force in a sensing mode when an external angular velocity is input to the frame; and at least two sensing electrode for sensing a displacement of the sensor mass body, the displacement being sensed at the two degrees of freedom, wherein the sensor mass body comprises an inner mass body and an outer mass body surrounding the inner mass body, the outer mass body and the frame are connected by a first support spring, and the outer mass body and the inner mass body are connected by a second support spring.

[Advantageous Effects of Invention]

According to the MEMS gyroscope in accordance with the present invention, the excitation resonant frequency is designed to fall within a frequency band between two sensing resonant frequencies. As a result, the sensing amplitude of each sensor mass body within a single wafer can be substantially uniformly maintained to be within a predetermined range regardless of micro-machining errors for a gyro structure. Also, the sensing amplitude of each sensor mass body can be substantially uniformly maintained to be within a predetermined range even when the structure contracts and expands in accordance with temperature variations or the vacuum pressure inside a package varies.

In addition, since two sensor mass body units are excited in opposite directions by a vertical seesaw mechanism and an anti-phase link mechanism is provided between the two sensor mass body units, a prefect anti-phase motion can be ensured even in a sensing mode.

Moreover, since two mass bodies are arranged in an embedded manner, unlike in a conventional MEMS gyroscope where two mass bodies are connected in a simple serial manner, the fabrication of a MEMS gyroscope can be facilitated, and the uniformity of sensing amplitude can be maintained even in the presence of processing errors.

[BRIEF DESCRIPTION OF DRAWINGS]

FIG. 1 is a schematic view illustrating a conventional z-axis MEMS gyroscope having a one-Degree-Of-Freedom (DOF) horizontal excitation/one-DOF horizontal sensing function.

FIG. 2 is a schematic view illustrating a conventional x-axis (or y-axis) MEMS gyroscope having a one-DOF horizontal excitation/one-DOF vertical sensing function.

FIG. 3 is a view showing a frequency response curve of a z-axis gyroscope in a conventional one-DOF horizontal excitation/one-DOF horizontal sensing mode or an x- or y-axis gyroscope in a conventional one-DOF horizontal excitation/one-DOF vertical sensing mode.

FIG. 4 is a view illustrating the operating principles of a z-axis gyroscope in a conventional one-DOF horizontal excitation/two-DOF horizontal sensing mode.

FIG. 5 is a view illustrating the operating principles of a z-axis gyroscope in a one-DOF horizontal excitation/two-DOF horizontal sensing mode according to the present invention.

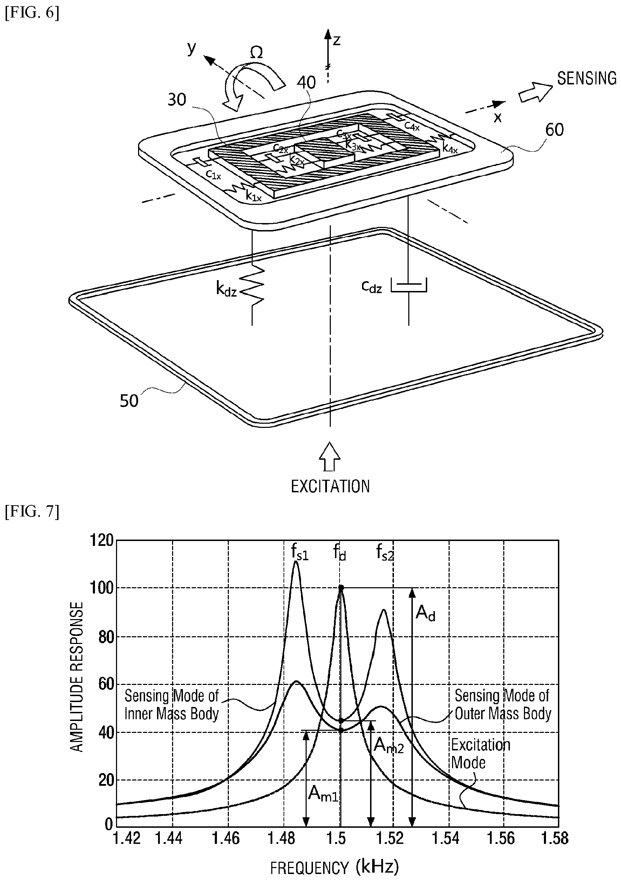

FIG. 6 is a view illustrating the operating principles of a x- or y-axis gyroscope in a one-DOF vertical excitation/two-DOF horizontal sensing mode according to the present invention.

FIG. 7 is a view showing a frequency response curve of an x- or y-axis gyroscope in a one-DOF vertical excitation/two-DOF horizontal sensing mode according to the present invention, as shown in FIG. 6.

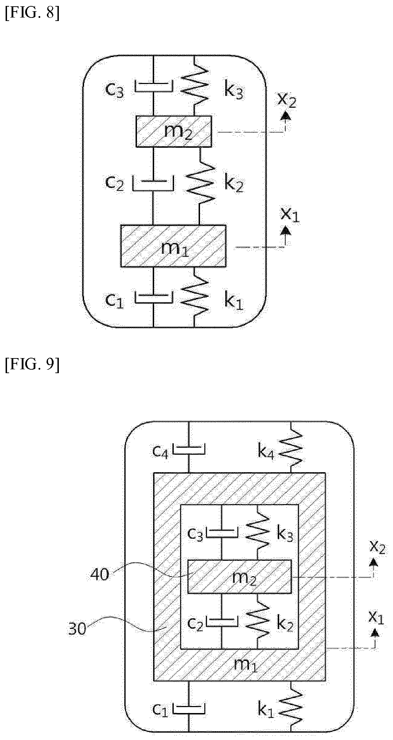

FIG. 8 is a schematic view of a conventional gyroscope having a serial-type mass body arrangement.

FIG. 9 is a schematic view of a gyroscope having an embedded mass body arrangement according to an exemplary embodiment of the present invention.

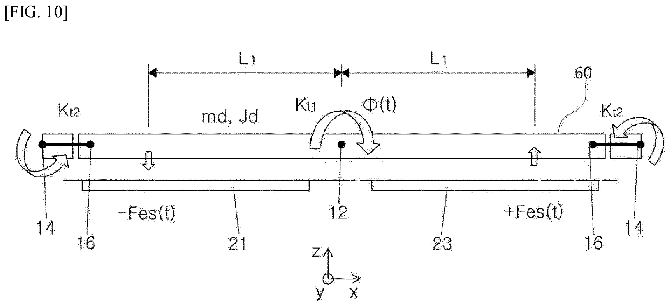

FIG. 10 shows a one-DOF mathematical model for an x- or y-axis gyroscope according to an exemplary embodiment of the present invention, particularly, for a gyro frame, which is vertically excited, and torsion support springs.

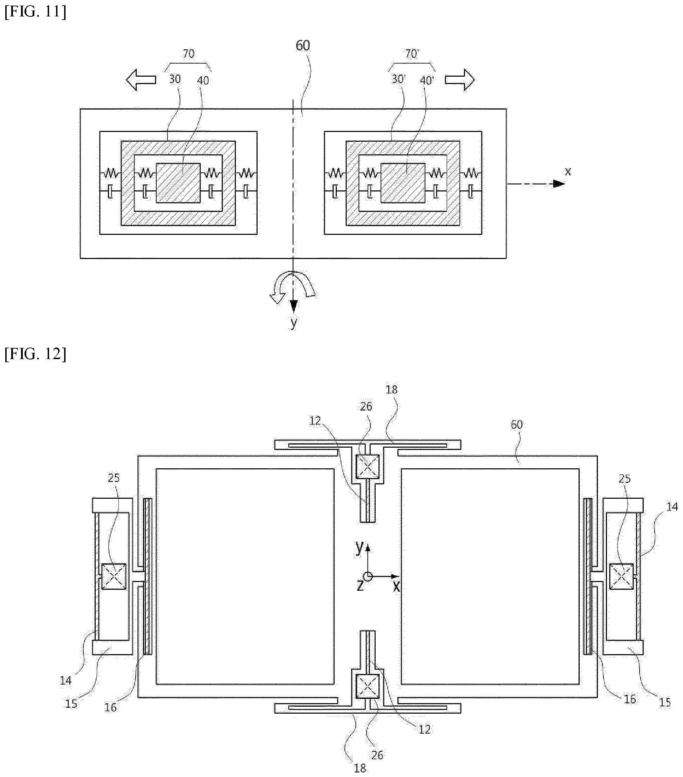

FIG. 11 illustrates the structure of a tuning fork-type MEMS gyroscope in which two mass body units are arranged in a gyro frame 60 to be linearly symmetrical in an x-axis direction.

FIG. 12 is a schematic view illustrating a MEMS gyroscope according to the invention, particularly, a frame, which enables the arrangement of two mass body units in linear symmetry in an x-axis direction, and support springs, which connect the frame to anchors.

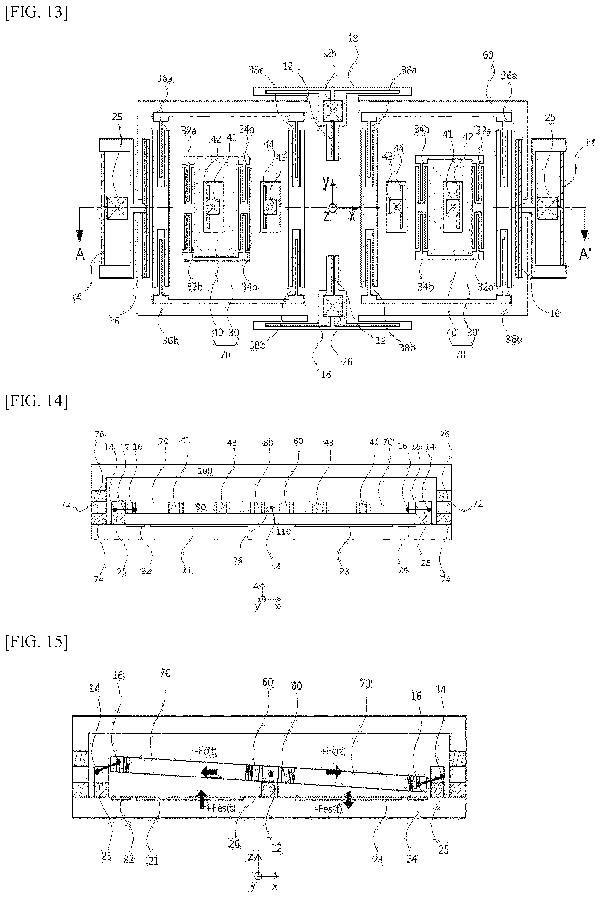

FIG. 13 is a view illustrating the structure of an x- or y-axis gyroscope according to an exemplary embodiment of the present invention that is vertically excited and horizontally sensed on an x-y plane.

FIG. 14 is a schematic cross-sectional view, taken along line A-A', of the x- or y-axis gyroscope of FIG. 13.

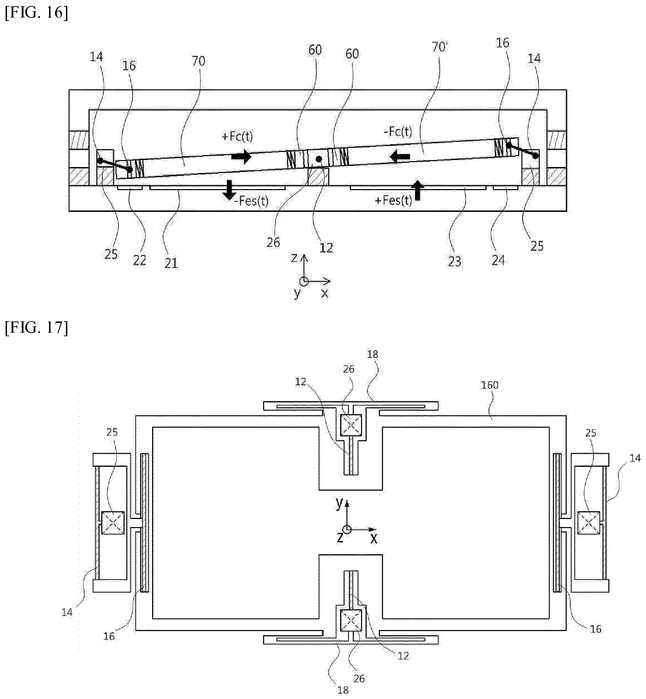

FIGS. 15 and 16 schematically illustrate a state where vertical excitation is caused by the bottom electrodes of FIG. 13.

FIG. 17 is a schematic view illustrating a frame according to another exemplary embodiment of the present invention that allows a link mechanism capable of enabling two mass body units to perform an anti-phase sensing-mode operation in the x- or y-axis gyroscope of FIG. 13.

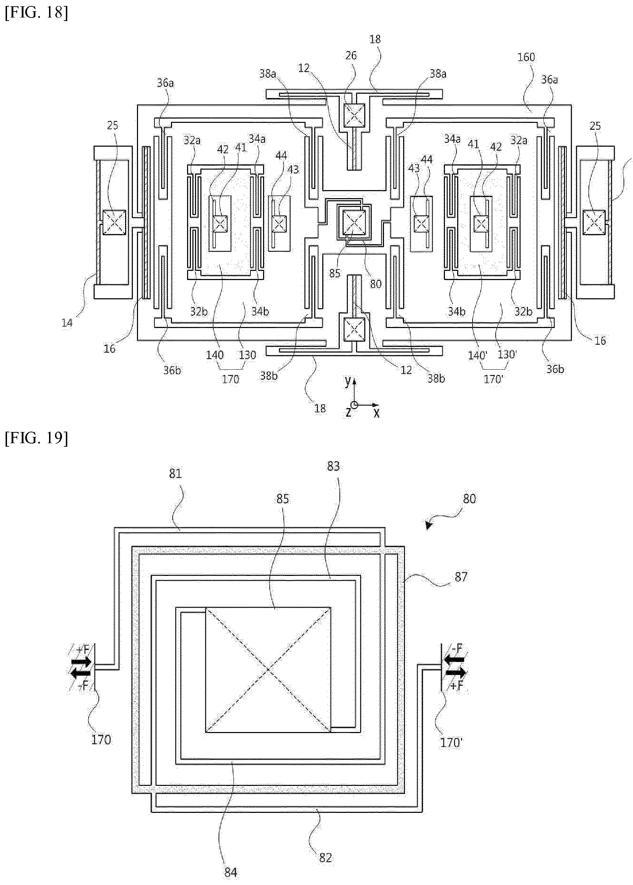

FIG. 18 illustrates the structure of the x- or y-axis gyroscope according to the exemplary embodiment of FIG. 17, which has an anti-phase link mechanism disposed therein and is vertically excited and horizontally sensed on an x-y plane.

FIG. 19 illustrates an anti-phase link mechanism according to an exemplary embodiment of the present invention.

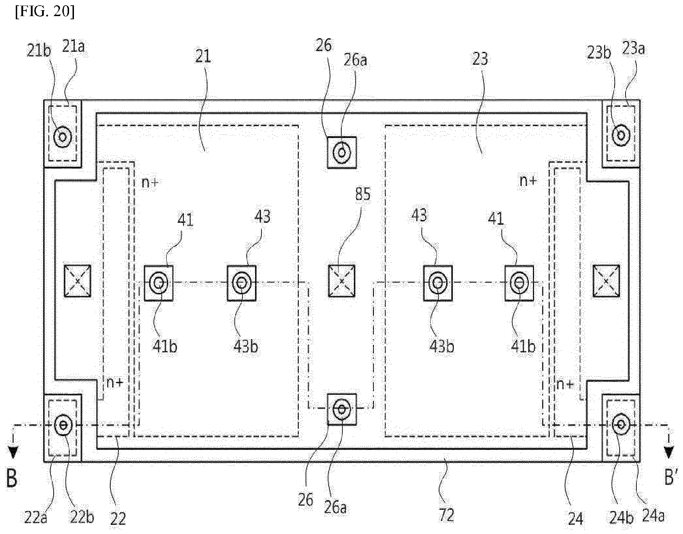

FIG. 20 is a schematic plan view illustrating the x- or y-axis gyroscope according to the exemplary embodiment of FIG. 18, particularly, n or p electrodes at the front surface of a bottom wafer, dummy metal pads at the front surface of the bottom wafer, and silicon through electrodes and sealing walls of the bottom wafer.

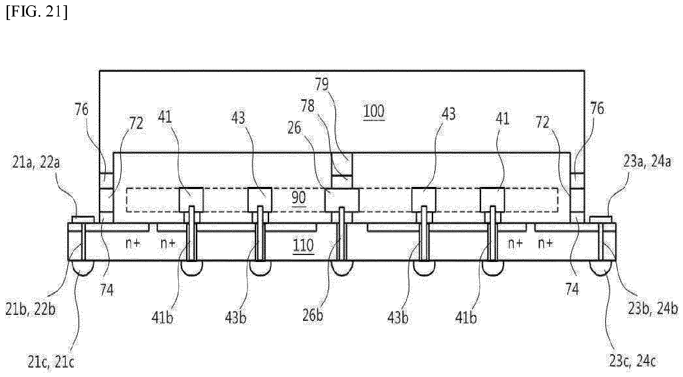

FIG. 21 is a schematic cross-sectional view, taken along line B-B', of the x- or y-axis gyroscope of FIG. 20.

[BEST MODES FOR CARRYING OUT THE INVENTION]

Advantages and features of the present invention and methods of accomplishing the same may be understood more readily by reference to the following detailed description of exemplary embodiments and the accompanying drawings. The present invention may, however, be embodied in many different provides and should not be construed as being limited to the embodiments set forth herein. Rather, these embodiments are provided so that this disclosure will be thorough and complete and will fully convey the concept of the present invention to those skilled in the art, and the present invention will only be defined by the appended claims. Like reference numerals refer to like elements throughout the specification. Furthermore, the expression "and/or", as used herein, includes any and all combinations of the associated listed words.

Exemplary embodiments of the present invention will be described with reference to plan views and/or cross-sectional views by way of ideal schematic views. Accordingly, the exemplary views may be modified depending on manufacturing technologies and/or tolerances. Therefore, the disclosed exemplary embodiments are not limited to those shown in the views, but include modifications in configuration formed on the basis of manufacturing processes. Therefore, regions exemplified in figures may have schematic properties, and shapes of regions shown in figures may exemplify specific shapes of regions of elements to which aspects of the present invention are not limited.

Exemplary embodiments of the present invention will hereinafter be described with reference to the accompanying drawings.

FIG. 5 is a view illustrating the operating principles of a z-axis gyroscope according to an exemplary embodiment of the present invention, which is horizontally excited and horizontally sensed. Referring to FIG. 5, if a sensor 20 is excited in an x-axis direction under the condition where a rotation $\Omega$ in a z-axis direction is applied to a frame 10 on a gyro wafer, the amplitude of a sensor mass body (30 and 40) is detected in a y-axis direction by a Coriolis force. Here, the sensor mass body (30 and 40) includes an outer mass body 30 and an inner mass body 40 completely surrounded by the outer mass body 30. The two sensor mass bodies 30 and 40 may be modeled as being connected by springs $k_{2y}$ and $k_{3y}$, which are arranged in the y-axis direction, and attenuators $c_{2y}$ and $c_{3y}$, and the sensor 20 and the outer mass body 30 may be modeled as being connected by other springs $k_{1y}$ and $k_{4y}$, which are arranged in the y-axis direction, and other attenuators $c_{1y}$ and $c_{4y}$. Also, the frame 10 and the sensor 20 may be modeled as being connected by a spring $k_{dx}$, which is arranged in the x-axis direction, and an attenuator $c_{dx}$.

FIG. 6 is a view illustrating the operating principles of an x- or y-axis gyroscope according to an exemplary embodiment of the present invention, which is vertically excited and horizontally sensed. Referring to FIG. 6, if a sensor mass body (30 and 40) is excited in an x-axis direction under the condition where a rotation $\Omega$ in a y-axis direction is applied to a bottom wafer 50 and a frame 60, the amplitude of the sensor mass body (30 and 40) is detected in the x-axis direction by a Coriolis force. Here, the sensor mass body (30 and 40) includes an outer mass body 30 and an inner mass body 40 completely surrounded by the outer mass body 30. The two sensor mass bodies 30 and 40 may be modeled as being connected by springs $k_{2x}$ and $k_{3x}$, which are arranged in the x-axis direction, and attenuators $c_{2x}$ and $c_{3x}$, and the frame 60 and the outer mass body 30 may be modeled as being connected by other springs $k_{1x}$ and $k_{4x}$, which are arranged along the x-axis direction, and other attenuators $c_{1x}$ and $c_{4x}$. Also, the bottom wafer 50 and the sensor frame 60 may be modeled as being connected by a spring $k_{dz}$, which is arranged in a z-axis direction, and an attenuator $c_{dz}$.

FIG. 7 shows a frequency response curve of an x- or y-axis gyroscope having a one-DOF vertical excitation mode and a two-DOF horizontal sensing mode, like the gyroscope of FIG. 6. Assuming that referring to FIG. 6, x-axis displacements of the outer mass body 30 and the inner mass body 40 with respect to an equilibrium position in the absence of an external force are $x_1$ and $x_2$, respectively, the sensor mass body (30 and 40) has two-DOF according to the parameters $x_1$ and $x_2$. The two parameters $x_1$ and $x_2$ have peak resonance frequencies $f_{s1}$ and $f_{s2}$, respectively, which are the same. If the sensor mass body (30 and 40) of FIG. 6 is vertically excited at a maximum excitation amplitude $A_d$ and at an excitation frequency $f_d$, the outer mass body 30 and the inner mass body 40 have linear vibration having maximum amplitudes $A_{m1}$ and $A_{m2}$, respectively, due to a Coriolis force $F_c$ in an x-axis direction. Thus, the amplitude response of the two mass bodies 30 and 40 has a relatively gentle slope between two peak resonant frequencies. Accordingly, even if the position of the excitation frequency slightly changes or an error such as, for example, a design error in the peak resonant frequency, occurs in the process of fabricating a MEMS gyro, the sensing amplitude of each of the mass bodies 30 and 40 falls within a stable range.

As compared to the amplitude response of FIG. 7, the amplitude response of FIG. 3, which has a one-DOF sensing mode, has a steep slope not only in an excitation mode, but also in a sensing mode. Accordingly, even a slight design error results in a considerable variation in sensing amplitude. Therefore, by allowing two mass bodies to have a two-DOF sensing mode, as in the exemplary embodiments of FIGS. 5 and 6, a MEMS gyroscope that is further robust against a processing error can be provided.

On the other hand, the prior art as shown in FIG. 4 can also provide the same benefit of imparting robustness against a processing error with the use of a 2 DOF sensing mode. However, the technique of FIG. 4 connects two mass bodies of a z-axis gyro in a simple serial manner. On the other hand, exemplary embodiments of the present invention (as shown in FIGS. 5 and 6) arrange two mass bodies in a z-axis gyro or an x- or y-axis gyro in an embedded manner. The arrangement of two mass bodies in the embedded manner has several advantages over the conventional technique of connecting two mass bodies in the simple serial manner.

First, a kinetic differential equation for two mass bodies arranged in the embedded manner is relatively simpler than that for two mass bodies connected in a serial manner. This becomes apparent from FIG. 8, which illustrates the arrangement of two mass bodies in the simple serial manner, and FIG. 9, which illustrates the arrangement of two mass bodies in the embedded manner.

The kinetic differential equation for FIG. 8 includes three connecting elements (k1 through k3 or c1 through c3) for not only connecting two mass bodies together, but also connecting the two mass bodies to a frame. On the other hand, the kinetic differential equation for FIG. 9 appears to have four connecting elements (k1 through k4 or c1 through c4). However, spring stiffnesses k1 and k4 may be merged into a single spring stiffness, i.e., ka, and k2 and k3 may be merged into a single spring stiffness, i.e., kb. Similarly, attenuation coefficients c1 and c4 may be merged into a single coefficient, i.e., ca, and c2 and c3 may be merged into a single coefficient, i.e., cb. Thus, the kinetic differential equation for FIG. 8 can be represented by two mass bodies and two connecting elements (ka and kb or ca and cb). The simplification of the kinetic differential equation facilitates the design of the target frequency and amplitude of a MEMS gyroscope, which may lead to a decrease in the occurrence of processing errors during the fabrication of a MEMS gyroscope.

Second, the arrangement of two mass bodies in the simple serial manner, as shown in FIG. 8, does not make it easy to design a MEMS gyroscope because in a second vibration mode, i.e., a mode where two mass bodies have a phase difference of 180 degrees and move in opposite directions, a design target forms a complete phase shift. On the other hand, the arrangement of two mass bodies in the embedded manner, as shown in FIG. 9, prevents, or at least alleviates, this problem because even if two mass bodies move in opposite directions, the inner mass body is included in the outer mass body.

Lastly, assuming that other conditions are the same and the sum of the masses of two mass bodies is also the same, displacements detected from the two mass bodies become larger as the difference between the masses of the two mass bodies increases. That is, by increasing the difference between the masses of the two mass bodies, the displacement of the smaller one of the two mass bodies body can be increased, and as a result, sensing sensitivity can be enhanced. However, in order to increase the difference between the masses of the two mass bodies, the difference between the sizes of the two mass bodies needs to be increased. However, in the simple serial arrangement of two mass bodies, as shown in FIG. 8, the difference between the sizes of the two mass bodies may degrade the structural symmetry (particularly, the symmetry in an x-axis direction) and may thus lower mechanical stability. In contrast, the embedded-type arrangement of two mass bodies, as shown in FIG. 9, does not deteriorate structural symmetry because of its inherent characteristics, even if the inner mass body 40 is sufficiently smaller than the outer mass body 30. This structural symmetry can provide robustness against various noise or sensing errors.

Referring again to FIG. 6, in the x- or y-axis gyroscope according to the present invention, the two mass bodies 30 and 40 are excited vertically and are sensed horizontally. This method can address the difficulty in arranging electrodes that arises when the mass bodies are excited and sensed horizontally, as in the conventional technique of FIG. 2. In an exemplary embodiment, a seesaw-type excitation method may be used to facilitate excitation in a vertical direction within a narrow gap between a bottom wafer and a MEMS wafer (or frame).

FIG. 10 shows a one-DOF mathematical model for an x- or y-axis gyroscope according to an exemplary embodiment of the present invention, particularly, for a gyro frame 60, which is vertically excited, and torsion support springs (12, 14, and 16). Referring to FIG. 10, the frame 60 is excited in a seesaw manner by bottom electrodes 21 and 23 so as to have anti-phase vibration components in a vertical direction with respect to the center of the frame (i.e., the location of torsion support springs 12. Thus, assuming that an excitation force at a location L1 apart, to the right, from the center of the frame 60 is +Fes(t), an excitation force at a location L1 apart, to the left, from the center of the frame 60 is -Fes(t). Due to these excitation forces being laterally reversed from each other, a Coriolis force resulting from an external rotational motion in a y-axis direction also has anti-phases laterally.

A vibration equation for the frame 60 of FIG. 10 is expressed by Equation (1) below.

【Equation 1】

$$J_d\ddot{\phi}(t) + (kt_1 + kt_2)\phi(t) = 2L_1 F_{es}(t)$$

Here, Jd denotes the moment of inertia of the entire frame 60 including sensor mass bodies 70 and 70', and $kt_1$ and $kt_2$ respectively denote the torsional stiffness of the beams of the support springs 12 and the torsional stiffness of the beams of support springs 14. $2L_1Fes(t)$, which is the right term of Equation (1), denotes a torque caused by an electrostatic force Fes(t) between the frame 60 and the bottom electrodes 21 and 23, and $\Phi(t)$ denotes the rotational angle of the frame 60 with respect to the y-axis.

The resonant frequency of the frame 60, calculated by the vibration equation for the frame 60, is expressed by Equation (2) below.

【Equation 2】

$$f_d = sqrt\,[(kt_1 + kt_2)/J_d]$$

Meanwhile, the excitation mode as shown in FIG. 10 has a one-DOF kinetic differential equation, whereas the sensing mode of the sensor mass body (30 and 40) of FIG. 9 has a two-DOF kinetic differential equation. Here, when the effect of an attenuation coefficient c is ignored, the kinetic differential equations may become as shown below.

【Equation 3】

$$m_1\ddot{x}_1 + k_a x_1 + k_b(x_1 - x_2) = 2m_1 v\Omega$$

$$m_2\ddot{x}_2 - k_b(x_1 - x_2) = 2m_2 v\Omega$$

Here, m1 and m2 denote the masses of the outer mass body 30 and the inner mass body 40, respectively, and x1 and x2 denote the displacements, in an x-axis direction, of the outer mass body 30 and the inner mass body 40, respectively. ka is the sum of k1 and k4 of FIG. 9, and kb is the sum of k2 and k3. Also, v denotes an excitation velocity in a z-axis direction, and $\Omega$ denotes a rotational angular velocity in the y-axis direction, received from the outside. Two sensing resonant frequencies (i.e., fs1 and fs2 of FIG. 7) for x1 or x2 can be obtained from the above two kinetic differential equations.

In the meantime, an ultra-small precision instrument such as a MEMS gyroscope is required to have a structure that exhibits robustness and stability against external noise and processing errors. However, a single mass body unit consisting of a single outer mass 30 and a single inner mass 40 may not have as robust and stable a structure as required. Accordingly, in an exemplary embodiment of the present invention, two mass body units are arranged in the x-axis direction and are allowed to have perfect anti-phases. These anti-phases are basically provided by anti-phase excitation in the vertical direction in accordance with the seesaw mechanism shown in FIG. 10.

FIG. 11 illustrates the structure of a MEMS gyroscope in which two mass body units are arranged in a gyro frame 60 to be linearly symmetrical in an x-axis direction. When an external rotation in a y-axis direction is applied to the MEMS gyroscope, a mass body unit 70 on the left and a mass body unit 70' on the right have anti-phase displacements. Thus, if the MEMS gyroscope has structural symmetry and the motion of the sensor mass bodies also has symmetry, processing errors or errors that may be caused by external noise can be offset, and as a result, the precision of the MEMS gyroscope can be improved.

A method of implementing a MEMS gyroscope according to an exemplary embodiment of the present invention will hereinafter be described. FIG. 12 is a schematic view illustrating a frame 60 and support springs (12, 14, and 16), which connect the frame 60 to anchors (25 and 26), of an x- or y-axis gyroscope. In an exemplary embodiment, the frame 60 is allowed to be torsionally rotated about the y axis by two support springs 12 attached to the sidewalls of anchors 26. Support springs 14 cause a restoring torque on an x-y plane and thus help both ends of the frame 60 in an x-axis direction to be torsionally deformed and then to return to their normal positions.

Support springs 16 serve as a link or a rotary bearing for connecting the ends of the frame 60 and the support springs 14. Also, flat plate links 15 are links that mechanically connect the support springs 14 and the support springs 16. Double-fold dummy beam springs 18, which are horizontally and vertically symmetrical, are attached to both anchors 26 of the frame 60 and thus simultaneously suppress both the deformation of the frame 600 in the direction (x) of a Coriolis force and the rotational motion of the frame 60 with respect to a vertical axis (z).

FIG. 13 illustrates the structure of an x- or y-axis gyroscope according to an exemplary embodiment of the present invention that is vertically excited and horizontally sensed on an x-y plane. In an exemplary embodiment, in order to support linear vibration in a direction (x) of a Coriolis force, a sensor mass body unit 70 or 70' is connected to a frame 60 in an x-axis direction by two pairs of support springs (36a, 36b, 38a, and 38b) that are a predetermined distance apart from the center of the sensor mass body unit 70 or 70' either horizontally or vertically with respect to a y axis. The sensor mass body unit 70 or 70' includes an outer mass body 30 or 30' and an inner mass body 40 or 40', which is surrounded by the outer mass body 30 or 30'. Two pairs of support springs (32a, 32b, 34a, and 34b) that are a predetermined distance apart either horizontally or vertically with respect to the y axis are connected between the outer mass body 30 or 30' and the inner mass body 40 or 40'. Accordingly, relative displacements may be formed in the x-axis direction between the outer mass body 30 or 30' and the frame 60, and between the inner mass body 40 or 40' and the outer mass body 30 or 30'.

The operation of the sensor mass body unit 70 or 70' in the direction (x) of the Coriolis force may be detected based on variations in static capacitance caused by variations in the distances or the areas between the sensor mass body 70 or 70' and sensing electrodes 42 and 44. Specifically, the sensing electrode 42 is provided for sensing the vibration, in the x-axis direction, of the inner mass body 40 or 40' of the sensor mass body unit 70 or 70', and the sensing electrode 44 is provided for sensing the vibration, in the x-axis direction, of the outer mass body 30 or 30' of the sensor mass body unit 70 or 70'. Each of the sensing electrodes 42 and 44 may be implemented as a comb electrode or a plate electrode. The sensing electrodes 42 and 44 may be attached to the sides of anchors 41 and 43 fixed to the respective wafer substrates.

Actually, not all the two sensing electrodes 42 and 44 are needed to calculate the external angular velocity $\Omega$ in the y-axis direction. Since there are only three variables in the two kinetic differential equations of Equation (3), i.e., x1, x2, and $\Omega$, the external angular velocity $\Omega$ can be determined simply by detecting only x1 or x2 with a sensing electrode. However, x1 and x2 may both be detected for the purpose of compensating for any error, and as a result, the value of Q may be precisely calculated.

If it is desired to detect only one of the two variables x1 and x2 to obtain the external angular velocity $\Omega$, i.e., if it is desired to provide a sensing electrode for only one of two mass bodies, it is advantageous to choose one of the mass bodies with a relatively smaller mass, i.e., with a relatively larger sensing amplitude. A large detection amplitude means that the MEMS gyroscope has excellent detection performance. In the embedded sensor mass body structure according to the present invention, the amplitude detected from the inner mass body can be increased by appropriately reducing the ratio of the mass of the inner mass body to the mass of the outer mass body (hereinafter, the mass ratio). Considering the practically available range for the MEMS gyroscope, it can be seen that the mass ratio is in the range from 1/2 times to 1/10 times and simulation results show that excellent results can be produced at the mass ratio of about 1/3 times.

FIG. 14 is a schematic cross-sectional view, taken along line A-A', of the x- or y-axis gyroscope of FIG. 13. Referring to FIG. 14, in the x- or y-axis gyroscope of FIG. 8, there exists, between a bottom wafer 110 and a cap wafer 100, an inner space surrounded by sealing walls (72, 74, and 76). Support springs 12 enable the rotational vibration of the frame 60 about the y-axis, and support springs 14 enhance the vertical restoring force of the ends of the frame 60. Also, support springs 16 serve as a rotary bearing so that a torsional deformation around the y-axis and a bending deformation in the x-axis direction can both occur at the same time. The support springs 14, flat plate links 15, and the support springs 16 are the basic elements of a double link mechanism for mechanically connecting the ends of the frame and the anchors 25. The bottom electrodes 21 and 23, which are for the vertical excitation of the frame 60, and the bottom electrodes 22 and 24, which are for sensing a variation in capacitance resulting from the displacement of the frame 60 in the vertical direction, are disposed on the bottom wafer 110 below the frame 60 and the sensor mass bodies 70 and 70'.

FIGS. 15 and 16 schematically illustrate a state where vertical excitation is caused by the bottom electrodes of FIG. 13. Referring to FIG. 15, an electrostatic force +Fes(t) is generated in a positive z-axis direction by the bottom electrode 21, and an electrostatic force -Fes(t) is generated in a negative z-axis direction by the bottom electrode 23. Then, the frame 60 receives a rotational moment in a clockwise direction. Accordingly, the sensor mass body unit 70 receives a Coriolis force -Fc(t) in a negative x-axis direction and thus moves in the negative x-axis direction, and the sensor mass body unit 70' receives a Coriolis force +Fc(t) in a positive x-axis direction and thus moves in the positive x-axis direction. Referring to FIG. 16, an electrostatic force -Fes(t) is generated in the negative z-axis direction by the bottom electrode 21, and an electrostatic force +Fes(t) is generated in the positive z-axis direction by the bottom electrode 23. Then, the frame 60 receives a rotational moment in a counterclockwise direction. Accordingly, the sensor mass body unit 70 receives a Coriolis force +Fc(t) in the positive x-axis direction and thus moves in the positive x-axis direction, and the sensor mass body unit 70' receives a Coriolis force -Fc(t) in the negative x-axis direction and thus moves in the negative x-axis direction.

FIG. 17 is a schematic view illustrating an x- or y-axis gyroscope according to another exemplary embodiment of the present invention, particularly, a frame 160 and support springs (12, 14, and 16), which connect the frame 160 to anchors (25 and 26). In the exemplary embodiment of FIG. 12, a space for receiving the two sensor mass body units 70 and 70' is divided into left and right sections, but in the present exemplary embodiment, a receiving space inside the frame 160 is integrally formed.

FIG. 18 illustrates the structure of the x- or y-axis gyroscope according to the exemplary embodiment of FIG. 17, which is vertically excited and horizontally sensed on an x-y plane. In the present exemplary embodiment, in order to support linear vibration in a direction (x) of a Coriolis force, the sensor mass body unit 170 or 170' is connected to the frame 160 in an x-axis direction by two pairs of support springs (36a, 36b, 38a, and 38b) that are a predetermined distance apart either horizontally or vertically from the center of the sensor mass body unit 170 or 170' with respect to a y axis. The sensor mass body unit 170 or 170' includes an outer mass body 130 or 130' and an inner mass body 140 or 140', which is surrounded by the outer mass body 130 or 130'. Two pairs of support springs (32a, 32b, 34a, and 34b) that are a predetermined distance apart either horizontally or vertically with respect to the y axis are provided between the outer mass body 130 or 130' and the inner mass body 140 or 140'. Accordingly, relative displacements may be formed in the x-axis direction between the outer mass body 130 or 130' and the frame 160, and between the inner mass body 140 or 140' and the outer mass body 130 or 130'.

The operation of the sensor mass body unit 170 or 170' in the direction (x) of the Coriolis force may be detected based on variations in static capacitance caused by variations in the distances or the areas between the sensor mass body 170 or 170' and sensing electrodes 42 and 44. Specifically, the sensing electrode 42 is provided for sensing the vibration, in the x-axis direction, of the inner mass body 140 or 140' of the sensor mass body unit 170 or 170', and the sensing electrode 44 is provided for sensing the vibration, in the x-axis direction, of the outer mass body 130 or 130' of the sensor mass body unit 170 or 170'. Each of the sensing electrodes 42 and 44 may be implemented as a comb electrode or a plate electrode. The sensing electrodes 42 and 44 may be attached to the sides of anchors 41 and 43 fixed to the respective wafer substrates.

In particular, in the exemplary embodiment of FIG. 18, the two mass body units are connected to a second end of an anti-phase link mechanism 80 whose first end is fixed to an anchor 85 fixed at one end to an anchor 85. As described above, in the present invention, two mass body units are disposed in the x-axis direction to have anti-phases. These anti-phases are basically provided by anti-phase excitation in the vertical direction in accordance with the seesaw mechanism shown in FIG. 10. Thus, if the motion of sensor mass bodies has symmetry in addition to the structural symmetry of a MEMS gyroscope, noise components generated for various reasons can be offset. Thus, the perfect anti-phase motion of sensor mass body units is one of the goals to be pursued in the manufacture of a MEMS gyroscope.

Therefore, in order to ensure that the two sensor mass bodies 170 and 170' have perfect anti anti-phase motion in a sensing mode, the two sensor mass bodies 170 and 170' according to the exemplary embodiment of FIG. 18 are connected to the anti-phase link mechanism 80, which is disposed near the center of the frame 160. Due to the structural characteristics (i.e., the rotationally symmetrical structure) of the anti-phase link mechanism 80, when a force is applied to one of the two link arms in a particular direction, a force in the exact opposite direction to the applied force, i.e., an anti-phase force, acts upon the other arm.

FIG. 19 illustrates an anti-phase link mechanism according to an exemplary embodiment of the present invention. An anti-phase link mechanism 80 includes two anchor connecting portions 83 and 84, which are connected to a central anchor 85 that is motionless with respect to the frame 160, and two anchor arms 81 and 82, which are connected to the two anchor connecting portions 83 and 84 and are rotationally symmetrical by 180 degrees with respect to the center of the anti-phase link mechanism 80. The anti-phase link mechanism 80 further includes a torsional stiffness supporting portion 87, which imparts torsional stiffness to the anti-phase link mechanism 80 and is formed in the shape of a closed curve passing through the points where the two anchor connecting portions 83 and 84 and the two link arms 81 and 82 meet. The torsional stiffness supporting portion 87 geometrically connects a first structure including the first anchor connecting portion 83 and the first link arm 81 and a second structure including the second anchor connecting portion 84 and the second link arm 82. If the torsional stiffness supporting portion 87 does not exist, no anti-phase force may be generated because the first and second structures are simply connected to the central anchor 85 without any connecting points.

Referring to FIG. 19, when +F is applied to the end of the first link arm 81, -F is generated at the end of the second link arm 82 as a reaction force due to the 180-degree rotationally symmetrical structure of the anti-phase link mechanism 80. Similarly, when -F is applied to the end of the first link arm 81, +F is generated at the end of the second link arm 82 as a reaction force. Even in a case where perfect anti-phases in the motion of two sensor mass bodies cannot be ensured simply through the anti-phase excitation shown in FIG. 10, the two sensor mass bodies have perfect anti-phase motion because of the structural characteristics of the anti-phase link mechanism, and as a result, noise components can be offset and thereby eliminated.

FIG. 20 is a schematic plan view illustrating the x- or y-axis gyroscope according to the exemplary embodiment of FIG. 18, particularly, n or p electrodes (21, 22, 23, and 24) at the front surface of the bottom wafer, dummy metal pads (21a, 22a, 23a, and 24a) at the front surface of the bottom wafer, and silicon through electrodes (21b, 22b, 23b, 24b, 41b, and 43b) and the sealing walls 72 of the bottom wafer. FIG. 21 is a schematic cross-sectional view, taken along line B-B', of the x- or y-axis gyroscope of FIG. 20.

Referring to FIGS. 20 and 21, the sealing walls (72, 74, and 76) are walls that separate the inside from the outside for the vacuum sealing of the x- or y-axis gyroscope. The bottom electrodes 21 and 23 are n or p doped electrodes doped with boron or phosphorus in the wafer substrate and for vertically exciting the frame 60 or 160, and the bottom electrodes 22 and 24 are n or p doped electrodes for measuring a variation in the vertical gap of the frame 60 or 160. A silicon through electrode 26b of the bottom wafer 110 is wiring connection for supplying power to the frame 60 or 160 and the sensor mass body 170 or 170', and silicon through electrodes 41b and 43b of the bottom wafer 110 are wiring for outputting signals sensed by the sensor sensing electrodes 41a and 43a to the outside. Silicon through electrodes 21b and 23b of the bottom wafer are wiring for supplying power to the bottom electrodes 21 and 23, and silicon through electrodes 22b and 24b are wiring for sensing signals of the bottom electrodes 22 and 24.

The dummy metal pads (21a, 22a, 23a, and 24a), which are metal pads deposited, using a conductive metal, on doping electrodes (21, 22, 23, and 24) that are connected to the outside of the sealing walls, electrically connect the silicon through electrodes (21b, 22b, 23b, and 24b) and the doping electrodes (21, 22, 23, and 24). Columns 78 and 79 are provided between the cap wafer 100 and the gyro wafer 90 to distribute the vibrational energy of the frame 60 or 160 between the bottom wafer 110 and the cap wafer 100.

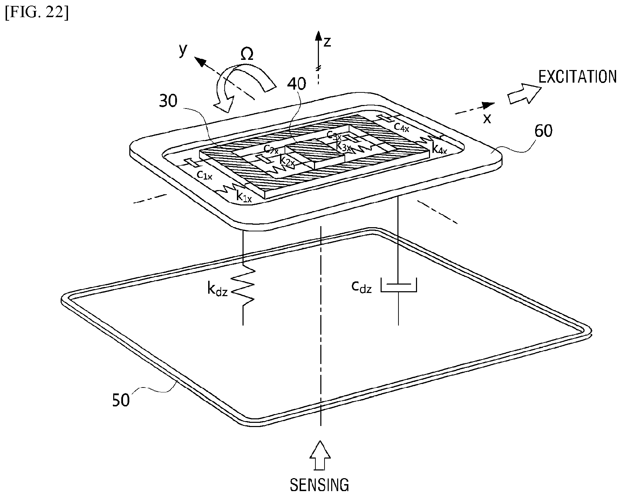

In the aforementioned exemplary embodiments, when excitation is performed in the z-axis direction in an external environment where rotation is applied in the y-axis direction, as shown in FIG. 6, the motion of the sensor mass body (30 and 40) may be detected in the x-axis direction, but the present invention is not limited thereto. Alternatively, a gyroscope (according to a modified exemplary embodiment) capable of sensing the motion of the sensor mass body (30 and 40) when excitation is performed in the x-axis direction in an environment where rotation is applied in the y-axis direction, as illustrated in FIG. 22, may be designed. That is, excitation may be performed in one axial direction in the frame 60, and sensing may be performed in a direction perpendicular to the frame 60. The excitation direction and the sensing direction of a gyroscope having the structure shown in FIG. 22 are opposite to the excitation direction and the sensing direction of the gyroscope of FIG. 6. Thus, existing excitation electrodes need to be replaced with sensing electrodes, and existing sensing electrodes need to be replaced with sensing electrodes.

Accordingly, a gyroscope according to the modified exemplary embodiment of FIG. 22 may be realized by allowing the sensing electrodes 42 and 44 of FIG. 13 to serve as excitation electrodes and allowing the electrodes 21 and 23 of FIG. 14, which are of a bottom electrode type, to serve as sensing electrodes. The sensing electrodes 42 and 44 are illustrated in FIG. 13 as being disposed in the inner mass body 40 or 40' and the outer mass body 30 or 30', respectively, but in a modified exemplary embodiment, excitation electrodes may be provided in the inner mass body 40 or 40' or the outer mass body 30 or 30', or in both the inner mass body 40 or 40' and the outer mass body 30 or 30'. Also, the excitation electrodes may be provided to excite the entire frame 60, in which case, the excitation electrodes may be implemented as comb electrodes or plate electrodes.

As described above, when the mass bodies of a gyroscope that is rotated in the y-axis direction by an external force are excited in the x-axis direction (see FIG. 13), the motion of the mass bodies is sensed in the z-axis direction by sensing electrodes, which are provided as the bottom electrodes 21 and 23 (see FIG. 14). This motion is a seesaw motion (or rotational motion) with respect to a central axis 12, i.e., the y axis, and the displacement of the mass bodies is sensed in the z-axis direction. Since the gyroscope includes the outer mass 30 and the inner mass 40, the bottom electrodes 21 and 23, which serve as sensing electrodes, may preferably be separated from, and disposed directly below, the mass bodies 30 and 40, respectively, to separately sense the displacement of the mass bodies 30 and 40 in the z-axis direction.

While exemplary embodiments are described above, it is not intended that these embodiments describe all possible forms of the present invention. Rather, the words used in the specification are words of description rather than limitation, and it is understood that various changes may be made without departing from the spirit and scope of the present invention. Additionally, the features of various implementing embodiments may be combined to form further exemplary embodiments of the present invention.

**Claims**

**1.** A MEMS gyroscope comprising:

a frame arranged parallel to a bottom wafer substrate;

a sensor mass body excited at one degree of freedom in an excitation mode, and of which the displacement is sensed at two degrees of freedom by a Coriolis force in a sensing mode when an external angular velocity is input to the frame; and

at least two sensing electrode for sensing a displacement of the sensor mass body, the displacement being sensed at the two degrees of freedom,

wherein the sensor mass body comprises an inner mass body and an outer mass body surrounding the inner mass body, the outer mass body and the frame are connected by a first support spring, and the outer mass body and the inner mass body are connected by a second support spring.

2. The MEMS gyroscope of claim 1, wherein the sensor mass body is excited at one degree of freedom by being either vertically vibrated with respect to the bottom wafer substrate by an electrostatic force, generated by at least one bottom electrode disposed on the bottom wafer substrate, or rotationally vibrated about one axis parallel to the bottom wafer substrate.

3. The MEMS gyroscope of claim 2, wherein the sensor mass has a two degree-of-freedom sensing mode including the vibration of the inner mass body by the Coriolis force and the vibration of the outer mass body by the Coriolis force, caused by an external angular velocity about one axis parallel to the bottom wafer substrate.

4. The MEMS gyroscope of claim 1, wherein a mass ratio of the inner mass body to the outer mass body is in a range from 1/2 to 1/10.

5. The MEMS gyroscope of claim 1, wherein the first support spring includes at least two springs, which connect the outer mass body and the frame in opposite directions, and the second support spring includes at least two springs, which connect the outer mass body and the inner mass body in opposite directions.

6. The MEMS gyroscope of claim 5, wherein two springs included in the first support spring and two springs included in the second support spring are of a linearly deformable beam type respectively.

7. The MEMS gyroscope of claim 1, wherein a connecting direction of the first support spring and a connecting direction of the second support spring are the same.

8. The MEMS gyroscope of claim 1, wherein the sensor mass body includes two mass body units, and the two mass body units are arranged to be linearly symmetrical with respect to the frame.

9. The MEMS gyroscope of claim 8, wherein each of the two mass body units includes at least one inner mass body and at least one outer mass body.

10. The MEMS gyroscope of claim 8, wherein each of the two mass body units are connected to a planar anti-phase link mechanism at a center of the frame, and the anti-phase motion of the two mass body units in a direction in which the displacement is sensed is ensured by the planar anti-phase link mechanism.

11. The MEMS gyroscope of claim 10, wherein the planar anti-phase link mechanism is fixed by an anchor, which is motionless, and is connected to the two mass body units at two link arms.

12. The MEMS gyroscope of claim 11, wherein the two link arms are rotationally symmetrical by 180 degrees with respect to a center of the planar anti-phase link mechanism.

13. The MEMS gyroscope of claim 8, wherein two bottom electrodes are disposed on the wafer substrate to be a predetermined distance apart from each other, and the frame has an anti-phase vertical-direction velocity component due to an anti-phase vertical-direction electrostatic force provided by the two bottom electrodes.

14. The MEMS gyroscope of claim 13, wherein when an external angular velocity about one axis parallel to the bottom wafer substrate is input, the two mass body units receive an anti-phase Coriolis force in a direction of another axis perpendicular to the angular velocity input axis and thus operate in opposite directions.

15. The MEMS gyroscope of claim 14, further comprising:

at least one of a torsion spring disposed at a center of the frame and providing a rotational restoring force for the frame and a horizontally symmetrical dual link-type torsion spring supporting both ends of the frame and providing a rotational restoring force for the frame.

[FIG. 1]

[FIG. 2]

[FIG. 3]

[FIG. 4]

[FIG. 5]

[FIG. 6]

[FIG. 7]

[FIG. 8]

[FIG. 9]

[FIG. 10]

[FIG. 11]

[FIG. 12]

[FIG. 13]

[FIG. 14]

[FIG. 15]

[FIG. 16]

[FIG. 17]

[FIG. 18]

[FIG. 19]

[FIG. 20]

[FIG. 21]

[FIG. 22]

## INTERNATIONAL SEARCH REPORT

International application No.

**PCT/KR2016/004855**

### A.    CLASSIFICATION OF SUBJECT MATTER

*G01C 19/5712(2012.01)i, B81B 7/02(2006.01)i*

According to International Patent Classification (IPC) or to both national classification and IPC

### B.    FIELDS SEARCHED

Minimum documentation searched (classification system followed by classification symbols)

G01C 19/5712; G01C 19/5621; G01P 9/04; H01L 29/84; B81B 3/00; G01C 19/56; B81B 7/02

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)

eKOMPASS (KIPO internal) & Keywords: sensor mass, Coriolis force, driving mode, detecting mode, angular speed, spring, MEMS gyroscopes

### C.    DOCUMENTS CONSIDERED TO BE RELEVANT

| Category* | Citation of document, with indication, where appropriate, of the relevant passages | Relevant to claim No. |
|---|---|---|
| Y | KR 10-2013-0084950 A (KOREA ADVANCED INSTITUTE OF SCIENCE AND TECHNOLOGY et al.) 26 July 2013<br>See paragraphs [0001], [0021]-[0029], claims 1, 5 and figures 6-12, 24-26. | 1-9,13-15 |
| A | | 10-12 |
| Y | KR 10-2003-0049313 A (SAMSUNG ELECTRONICS CO., LTD.) 25 June 2003<br>See pages 3, 4, claims 1-3 and figures 2-8. | 1-9,13-15 |
| A | JP 2014-160070 A (FREESCALE SEMICONDUCTOR INC.) 04 September 2014<br>See paragraphs [0015]-[0020] and figures 3-4. | 1-15 |
| A | JP 2012-047537 A (DENSO CORP.) 08 March 2012<br>See paragraphs [0022]-[0037] and figure 1. | 1-15 |
| A | JP 2001-021360 A (MITSUBISHI ELECTRIC CORP.) 26 January 2001<br>See paragraphs [0021]-[0027] and figures 1-4. | 1-15 |

☐  Further documents are listed in the continuation of Box C.        ☒  See patent family annex.

| | |
|---|---|
| *        Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| 29 AUGUST 2016 (29.08.2016) | **29 AUGUST 2016 (29.08.2016)** |

| Name and mailing address of the ISA/KR | Authorized officer |
|---|---|
| Korean Intellectual Property Office<br>Government Complex-Daejeon, 189 Seonsa-ro, Daejeon 302-701, Republic of Korea<br>Facsimile No. 82-42-472-7140 | Telephone No. |

Form PCT/ISA/210 (second sheet) (January 2015)

INTERNATIONAL SEARCH REPORT
Information on patent family members

International application No.

**PCT/KR2016/004855**

| Patent document cited in search report | Publication date | Patent family member | Publication date |
|---|---|---|---|
| KR 10-2013-0084950 A | 26/07/2013 | KR 10-1371149 B1 | 06/03/2014 |
| KR 10-2003-0049313 A | 25/06/2003 | EP 1319927 A1 | 18/06/2003 |
| | | EP 1319927 B1 | 13/04/2011 |
| | | JP 2003-194545 A | 09/07/2003 |
| | | JP 3811444 B2 | 23/08/2006 |
| | | KR 10-0436367 B1 | 19/06/2004 |
| | | US 2003-0110858 A1 | 19/06/2003 |
| | | US 6915693 B2 | 12/07/2005 |
| JP 2014-160070 A | 04/09/2014 | CN 103994760 A | 20/08/2014 |
| | | US 2014-0230549 A1 | 21/08/2014 |
| JP 2012-047537 A | 08/03/2012 | JP 5360020 B2 | 04/12/2013 |
| JP 2001-021360 A | 26/01/2001 | NONE | |

Form PCT/ISA/210 (patent family annex) (January 2015)

**EP 3 296 691 A1**

REFERENCES CITED IN THE DESCRIPTION

**Patent documents cited in the description**

- US 7284430 B